# FASCICULE DE BREVET EUROPEEN

(11) **EP 0 586 398 B1**
(45) Date de publication et mention de la délivrance du brevet: **02.11.1995**
(21) Numéro de dépôt: 92908638.7
(22) Date de dépôt: 28.02.1992
(51) Int. Cl.: G11C 19/28, G11C 27/04

(54) **REGISTRE A DECALAGE UTILISE COMME BALAYEUR DE LIGNES DE SELECTION POUR UN AFFICHEUR A CRISTAUX LIQUIDES**
SHIFTREGISTER ZUM ABTASTEN DER ANSTEURUNGSLEITUNGEN ZUR VERWENDUNG BEI EINER FLÜSSIGKRISTALLANZEIGE
SHIFT REGISTER USED AS SELECTION LINE SCANNER FOR LIQUID CRYSTAL DISPLAY

(30) Priorité: 28.02.1991 US 660272
(43) Date de publication de la demande: 16.03.1994
(73) Titulaire: THOMSON-LCD, 92800 Puteaux (FR)
(72) Inventeur: PLUS, Dora, F-92045 Paris-La Défense Cédex 67 (FR)
(74) Mandataire: Ruellan-Lemonnier, Brigitte
(86) Numéro de dépôt international: FR9200185
(87) Numéro de publication internationale: WO9215992

(56) Documents cités:
- US-A- 3 862 435
- PATENT ABSTRACTS OF JAPAN, vol. 8, no. 33 (P-254), 14 Février 1984;& JP-A-58188396

## Description

La présente invention concerne d'une manière générale les registres à décalage et en particulier un registre à décalage utilisé comme balayeur de lignes de sélection pour afficheurs à cristaux liquides.

Les afficheurs à cristaux liquides (LCD) pour la télévision et les ordinateurs sont connus dans la technique. On peut par exemple, se référer aux brevets américains 4.742.346 et 4.766.430, tous deux accordés à G.G.Gillette et al et pris ici comme référence. Les afficheurs du type décrit dans les brevets Gillette comprennent une matrice de cellules à cristaux liquides qui sont disposées aux croisements de lignes de données et de lignes de sélection. Les lignes de sélection sont sélectionnées séquentiellement par un balayeur de lignes de sélection pour produire les lignes horizontales de l'afficheur. Les lignes de données appliquent les signaux de brillance (échelle de gris) aux colonnes des cellules de cristaux liquides lorsque les lignes de sélection sont sélectionnées en séquence. Chaque cellule à cristal liquide est associée à un dispositif de commutation par lequel une tension en forme de rampe est appliquée aux cellules à cristaux liquides de la ligne sélectionnée. Chacun des dispositifs de commutation est tenu par un comparateur, ou un compteur, qui reçoit le signal de brillance pour permettre à la tension en forme de rampe de charger la cellule à cristal liquide associée à une tension proportionnelle au niveau de brillance reçu de la ligne de données par le comparateur.

Le circuit de commande, qui commande les lignes de données, et le balayeur de lignes de sélection, qui sélectionne les lignes horizontales à afficher, sont fabriqués de préférence directement sur le même substrat que les cellules à cristaux liquides en même temps que la fabrication des dispositifs de commutation. Aussi, parce qu'un grand nombre de lignes de données et de lignes de sélection sont nécessaires pour un afficheur pour télévision ou ordinateur, et parce que le faible pas des éléments d'images (pixels) limite l'espace disponible pour disposer le circuit de commande, il est essentiel de garder les circuits aussi simples que possible afin d'arriver à un haut rendement de fabrication. Il peut être aussi avantageux d'utiliser des dispositifs à semi-conducteurs du même type de conductivité dans tout l'afficheur. Pour ces raisons, il y a besoin d'un balayeur de lignes de sélection simple et fiable pouvant être utilisé dans les afficheurs à cristaux liquides. Le brevet Américain 3 862 435 de US PHILIPS Corporation propose un registre à décalage dont chacun des éléments comporte deux transistors et plusieurs capacités et/ou une diode. La présente invention répond au besoin de circuit simple et utilisant des dispositifs du même type de conductivité en utilisant un registre à décalage caractérisé en ce que chaque étage est composé d'un minimum de dispositifs à semi-conducteurs qui, de préférence, sont des transistors à couches minces (TFT), et qui peuvent tous être du même type de conductivité.

Cette invention peut être utilisée avec l'invention décrite dans la demande de brevet simultanée 660.274 déposée en même temps que la présente par Antoine DuPont et Dora Plus et intitulée "Registre redondant à décalage pour dispositifs de balayage".

Un registre à décalage selon la présente invention comporte une pluralité d'étages en cascade, chacun desdits étages ayant une borne d'entrée et une borne de sortie, ledit registre à décalage comportant des moyens de fournir une pluralité de signaux d'horloge déphasés et un signal d'entrée, caractérisé en ce que lesdits étages comprennent:
- un circuit de sortie comprenant un premier dispositif semiconducteur, commandé par un premier noeud, pour le transfert d'un premier signal d'horloge à ladite borne de sortie, et un second dispositif semiconducteur, commandé par un second noeud, disposé entre ladite borne de sortie et une source de tension de référence,
- un premier circuit de commutation comportant un troisième dispositif semiconducteur commandé par la borne de sortie de l'étage immédiatement précédent, et un quatrième dispositif semiconducteur commandé par le second noeud, leurs liaisons conductrices étant reliées en série au premier noeud,
- un second circuit de commutation comportant un cinquième dispositif semiconducteur commandé par un second signal d'horloge et disposé entre une source de tension de référence et le second noeud, ainsi qu'un sixième dispositif semiconducteur commandé par la borne de sortie de l'étage immédiatement précédent et disposé entre une source de référence et le second noeud.

La présente invention concerne aussi un écran à cristaux liquides à drivers intégrés (circuits de commande périphériques intégrés au substrat) comportant un registre à décalage tel que décrit dans le paragraphe précédent.

Ainsi, selon la présente invention, chaque étage comprend un circuit de sortie pour commuter la tension sur la borne de sortie entre des valeurs hautes et basses. Le circuit de sortie comprend un premier dispositif à semi-conducteurs pour transférer un des premiers signaux d'horloge à la borne de sortie et commuter la borne de sortie sur haut en réponse à un premier signal de commutation. Un deuxième dispositif à semi-conducteurs transfère une basse tension à la borne de sortie et commute la borne de sortie sur bas en réponse à un second signal de commutation. Les liaisons conductrices des dispositifs à semi-conducteurs sont reliées en série à la borne de sortie. Un premier noeud de commutation donne le premier signal de commutation en réponse au signal d'entrée. Un second noeud de commutation donne le second signal de commutation en réponse à un second signal d'horloge.

La Figure 1 est un schéma synoptique d'un registre à décalage incluant la pluralité de cascades réalisée selon la présente invention.

La Figure 2 est un mode de réalisation préférentiel des étages du registre à décalage montré sur la FIGURE 1.

Les Figures 3a et 3f montrent les profils d'onde des modes de réalisation préférentiels de la Figure 2.

La Figure 4 montre la relation de trois impulsions d'horloge et quatre impulsions de sortie.

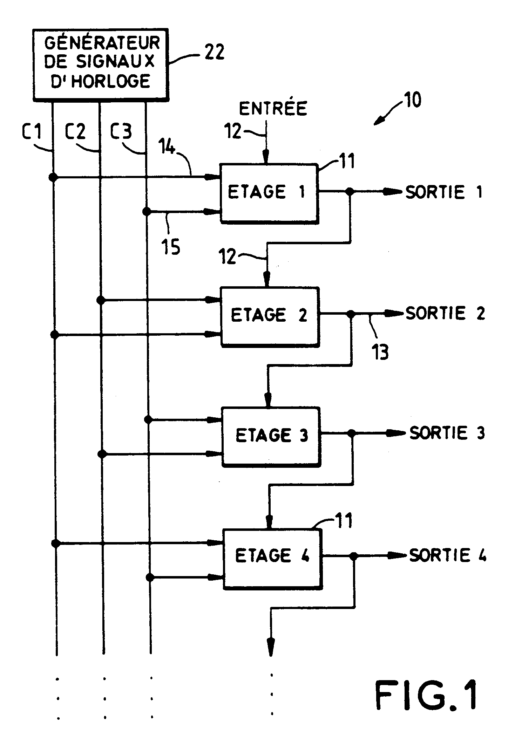

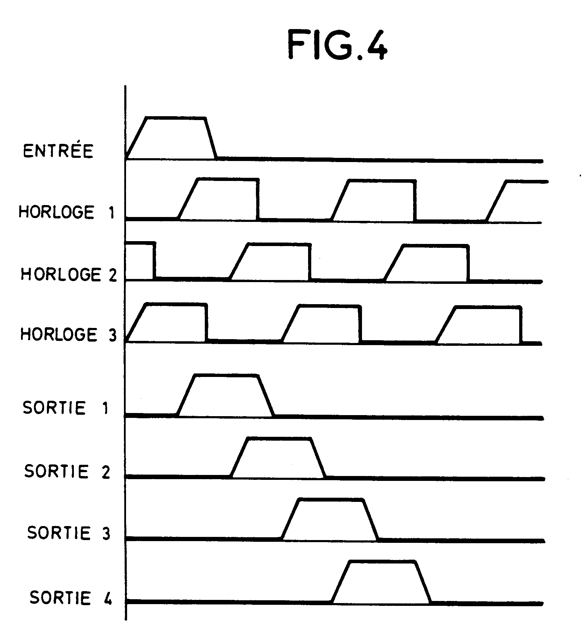

Sur la Figure 1, un registre à décalage 10, qui peut être utilisé comme balayeur de lignes de sélection pour un afficheur à cristaux liquides, comprend une pluralité d'étages 11 sensiblement identiques, chacun d'entre eux ayant une borne d'entrée 12 et une borne de sortie 13. Les étages 11 sont en cascade si bien que la borne de sortie 13 de chaque étage est reliée à la borne d'entrée 12 de l'étage suivant. Chaque étage 11 comprend aussi deux bornes d'entrée d'horloge 14 et 15. Un générateur d'impulsions 22 fournit trois signaux d'horloge déphasés C1, C2 et C3. Différentes paires de signaux d'horloge sont appliquées aux bornes d'horloge 14 et 15 de chaque étage et ainsi chaque étage reçoit une paire de signaux différente des paires reçues par les étages voisins. Les relations des impulsions d'horloge C1, C2, C3 et des quatre impulsions de sortie sont montrées sur la Figure 4.

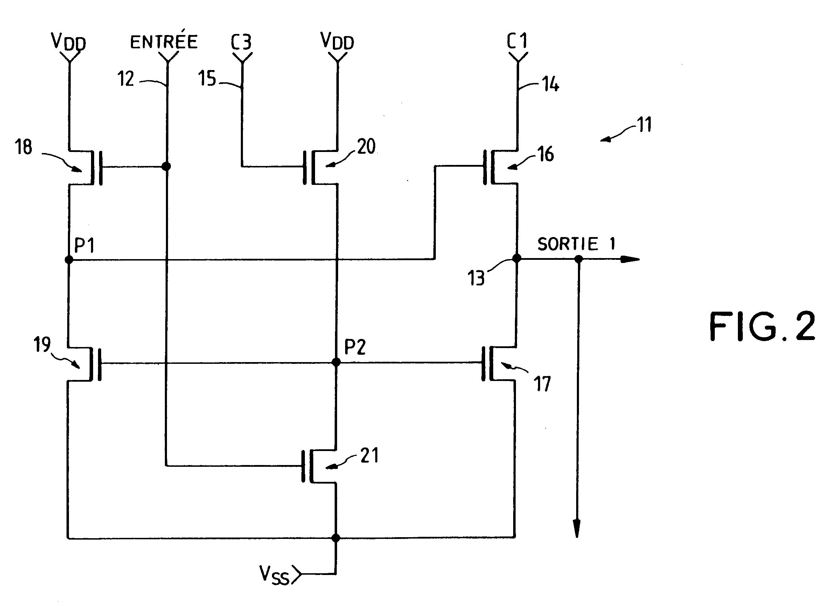

La Figure 2 est un mode de réalisation préférentiel des circuits inclus dans chacun des étages 11 de la Figure 1. Sur la Figure 2, un circuit de sortie comporte deux dispositifs à semi-conducteurs 16 et 17, qui sont de préférence des transistors à couches minces (TFT), dont les liaisons conductrices sont reliées en série à la borne de sortie 13. Un premier circuit de commutation comporte les dispositifs à semiconducteurs 18 et 19, qui sont aussi de préférence des TFT, avec leurs liaisons conductrices connectées en séries à un premier noeud de commutation P1. Un autre circuit de commutation comporte les dispositifs à semiconducteurs 20 et 21, qui sont aussi de préférence des TFT, avec leurs liaisons conductrices connectées en série à un second noeud de commutation P2.

Les drains des TFT 18 et 20 reçoivent une tension polarisante relativement positive V_{DD} et le drain du TFT 16 reçoit le signal d'horloge C1. Les sources des TFT 17, 19 et 21 reçoivent une tension polarisante relativement négative V_{SS}. Les électrodes de commande des TFT 18 et 21 répondent à la borne d'entrée 12. Les électrodes de commande des TFT 17 et 19 répondent au deuxième noeud de commutation P2. L'électrode de commande du TFT 16 répond au premier noeud de commutation P1, et l'électrode de commande du TFT 20 reçoit le signal d'horloge C3. Dans le mode de réalisation de la Figure 2, tous les TFT 16 à 20 ont le même type de conductivité et peuvent donc être fabriqués avec du silicium amorphe, par exemple.

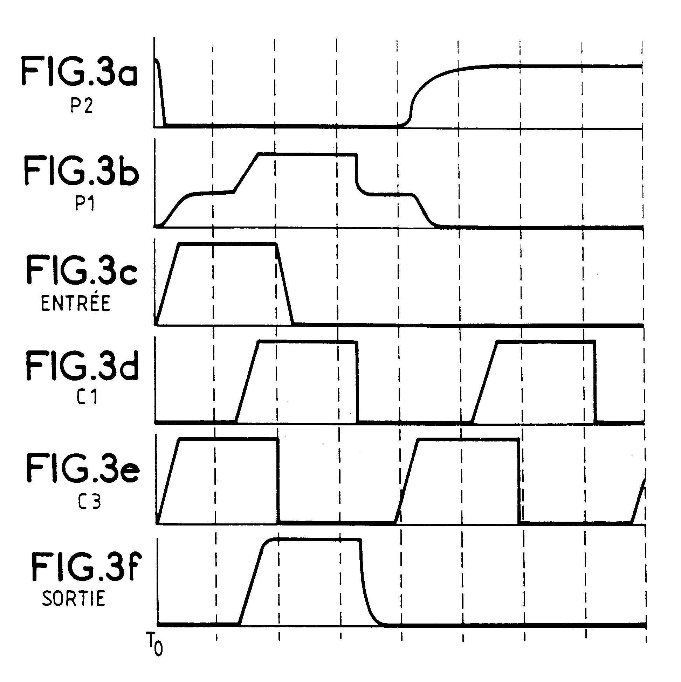

Le fonctionnement peut être compris à partir des Figures 2 et 3a à 3f. Les profils d'onde des Figures 3a à 3f sont pour des dispositifs de conductivité de type n. Supposons que les conditions présentes soient telles que celles montrées au temps T₀ sur les Figures 3a à 3f. Au temps T₀, le noeud P2 (Figure 3a) est élevé, le TFT 17 est passant et la borne de sortie 13 est à basse tension V_{SS}. Quand une impulsion d'entrée (Figure 3c) est appliquée à la borne d'entrée 12 et qu'une impulsion d'horloge C3 (Figure 3e) est appliquée à la borne d'horloge 15, les TFT 18, 20 et 21 commencent simultanément à être passants. En conséquence, le noeud P1 commence à devenir négatif (Figure 3b), à une tension égale à V_{DD} moins la tension de seuil V_{TH} du TFT 18 et le TFT 16 est passant. En même temps, le noeud P2 passe en état bas (Figure 3a) en raison de la mise sous forte tension du TFT 21. Avec le noeud P2 bas, le TFT 17 est bloqué, mais cependant la borne de sortie 13 reste basse parce que l'impulsion d'horloge C1 est basse et ainsi rien ne s'est passé pour faire passer le noeud en état haut. Quand une impulsion d'horloge élevée C1 (Figure 3d) est appliquée à la borne d'horloge 14, l'électrode de commande du TFT 16 est déjà passante et le couplage intrinsèque grille/drain fait passer le noeud P1 à une tension égale à V_{DD} - V_{TH} plus environ 90% de l'amplitude de l'impulsion d'horloge C1. Cela permet à la borne de sortie 13 (figure 3f) de suivre le signal d'horloge C1. L'impulsion de sortie met sous tension une ligne de sélection de l'afficheur, et donne aussi une impulsion d'entrée élevée à l'étage suivant. Les TFT 20 et 21 sont en rapport, le TFT 21 étant beaucoup plus grand que le TFT 20, par exemple 10 fois, il s'impose au TFT 20 ; le noeud P2 reste en état bas pendant la période de sélection pendant laquelle l'impulsion d'horloge C3 est élevée. Quand l'horloge C1 redevient basse, le noeud P1 revient à peu près à la tension préchargée. Quand l'impulsion d'horloge C3 s'élève, le noeud P2 passe en état haut, le TFT 17 est passant et le noeud de sortie 13 passe à l'état bas.

## Revendications

1. Registre à décalage (10) comportant une pluralité d'étages (11) en cascade, chacun desdits étages (11) ayant une borne d'entrée (12) et une borne de sortie (13), ledit registre à décalage comportant des moyens (22) de fournir une pluralité de signaux d'horloge déphasés (C1, C2, C3) et un signal d'entrée (12), caractérisé en ce que lesdits étages (11) comprennent:
- un circuit de sortie comprenant un premier dispositif semiconducteur (16), commandé par un premier noeud (P1), pour le transfert d'un premier signal d'horloge (C1) à ladite borne de sortie (13), et un second dispositif semiconducteur (17) , commandé par un second noeud (P2), disposé entre ladite borne de sortie (13) et une source de tension de référence (Vss),
- un premier circuit de commutation comportant un troisième dispositif semiconducteur (18) commandé par la borne de sortie (12,13) de l'étage (11) immédiatement précédent, et un quatrième dispositif semiconducteur (19) commandé par le second noeud (P2), leurs liaisons conductrices étant reliées en série au premier noeud (P1),
- un second circuit de commutation comportant un cinquième dispositif semiconducteur (20) commandé par un second signal d'horloge (C3) et disposé entre une source de tension de référence (Vdd) et le second noeud (P2), ainsi qu'un sixième dispositif semiconducteur (21) commandé par la borne de sortie (12,13) de l'étage (11) immédiatement précédent et disposé entre une source de référence (Vss) et le second noeud (P2).

2. Registre à décalage selon la revendication 1 caractérisé en ce que lesdits troisième (20) et quatrième (21) dispositifs semiconducteurs sont en rapport de manière à ce que ledit quatrième (21) dispositif semiconducteur soit sensiblement plus important que ledit troisième (20) dispositif semiconducteur pour maintenir ledit second noeud à un niveau désiré quand ledit troisième (20) dispositif semiconducteurs est passant.

3. Registre à décalage selon l'une quelconque des revendications précédentes, caractérisé en ce que lesdits dispositifs semiconducteurs (16,17,18,19,20,21) sont des transitors.

4. Registre à décalage selon la revendication 3, caractérisé en ce que lesdits transistors sont des transistors (16,17,18,19,20,21) à couches minces (TFT).

5. Afficheur à cristaux liquides comportant un circuit balayeur de lignes de sélection qui sélectionne les lignes horizontales à afficher , fabriqué sur le même substrat que les cellules à cristaux liquides, caractérisé en ce que ce balayeur de lignes de sélection comporte un registre à décalage selon l'une quelconque des revendications précédentes.

## Patentansprüche

1. Schieberegister (10), das eine Vielzahl von in Kaskade geschalteten Stufen (11) umfaßt, wobei jede der besagten Stufen (11) eine Eingangsklemme (12) und eine Ausgangsklemme (13) besitzt, wobei das besagte Schieberegister Mittel (22) zur Erzeugung einer Vielzahl von phasenverschobenen Taktsignalen (C1, C2, C3) und eines Eingangssignals (12) umfaßt, dadurch gekennzeichnet, daß die besagten Stufen (11) folgendes umfassen:
- eine Ausgangsschaltung, welche ein erstes Halbleiterbauelement (16) umfaßt, das von einem ersten Knotenpunkt (P1) so gesteuert wird, daß es ein erstes Taktsignal (C1) zu der besagten Ausgangsklemme (13) überträgt, und ein zweites Halbleiterbauelement (17), das von einem zweiten Knotenpunkt (P2) gesteuert wird und das zwischen der besagten Ausgangsklemme (13) und einer Bezugsspannungsquelle (Vss) angeordnet ist,
- einen ersten Schaltkreis, der ein drittes Halbleiterbauelement (18) umfaßt, das von der Ausgangsklemme (12,13) der unmittelbar vorangehenden Stufe (11) gesteuert wird, und ein viertes Halbleiterbauelement (19), das von dem zweiten Knotenpunkt (P2) gesteuert wird, wobei ihre leitenden Verbindungen mit dem ersten Knotenpunkt (P1) in Reihe geschaltet sind,
- einen zweiten Schaltkreis, der ein fünftes Halbleiterbauelement (20) umfaßt, das von einem zweiten Taktsignal (C3) gesteuert wird und zwischen einer Bezugsspannungsquelle (Vdd) und dem zweiten Knotenpunkt (P2) angeordnet ist, sowie ein sechstes Halbleiterbauelement (21), das von der Ausgangsklemme (12,13) der unmittelbar vorangehenden Stufe (11) gesteuert wird und zwischen einer Bezugsspannungsquelle (Vss) und dem zweiten Knotenpunkt (P2) angeordnet ist.

2. Schieberegister nach Anspruch 1, dadurch gekennzeichnet, daß das besagte dritte (20) und das besagte vierte (21) Halbleiterbauelement in einem bestimmten Verhältnis stehen, derart, daß das besagte vierte (21) Halbleiterbauelement wesentlich größer ist als das besagte dritte (20) Halbleiterbauelement, um den besagten zweiten Knotenpunkt auf einem gewünschten Pegel zu halten, wenn sich das besagte dritte (20) Halbleiterbauelement im Durchlaßzustand befindet.

3. Schieberegister nach einem der vorhergehenden Ansprüche, dadurch gekennzeichnet, daß die besagten Halbleiterbauelemente (16,17,18,19,20,21) Transistoren sind.

4. Schieberegister nach Anspruch 3, dadurch gekennzeichnet, daß die besagten Transistoren (16,17,18,19,20,21) Dünnschichttransistoren (TFT) sind.

5. Flüssigkristalldisplay, das eine Auswahlzeilen-Abtastschaltung umfaßt, welche die anzuzeigenden horizontalen Zeilen auswählt und auf dem gleichen Substrat hergestellt wird wie die Flüssigkristallzellen, dadurch gekennzeichnet, daß dieser Auswahlzeilen-Abtaster ein Schieberegister nach einem der vorhergehenden Ansprüche umfaßt.

## Claims

1. Shift register (10) including a plurality of cascaded stages (11), each of the said stages (11) having an input terminal (12) and an output terminal (13), the said shift register including means (22) for providing a plurality of phase shifted clock signals (C1, C2, C3) and an input signal (12), characterized in that the said stages (11) comprise:
- an output circuit comprising a first semiconductor device (16), controlled by a first node (P1), for the transfer of a first clock signal (C1) to the said output terminal (13), and a second semiconductor device (17), controlled by a second node (P2), placed between the said output terminal (13) and a reference voltage source (Vss),
- a first switching circuit including a third semiconductor device (18) controlled by the output terminal (12, 13) of the immediately preceding stage (11), and a fourth semiconductor device (19) controlled by the second node (P2), their conductive links being connected in series to the first node (P1),
- a second switching circuit including a fifth semiconductor device (20) controlled by a second clock signal (C3) and placed between a reference voltage source (Vdd) and the second node (P2), as well as a sixth semiconductor device (21) controlled by the output terminal (12, 13) of the immediately preceding stage (11) and placed between a reference source (Vss) and the second node (P2).

2. Shift register according to Claim 1, characterized in that the said third (20) and fourth (21) semiconductor devices are in a ratio such that the said fourth (21) semiconductor device is substantially more important than the said third (20) semiconductor device in respect of maintaining the said second node at a desired level when the said third (20) semiconductor device is on.

3. Shift register according to either one of the preceding claims, characterized in that the said semiconductor devices (16, 17, 18, 19, 20, 21) are transistors.

4. Shift register according to Claim 3, characterized in that the said transistors are thin film transistors (TFT) (16, 17, 18, 19, 20, 21).

5. Liquid crystal display including a select line scanner circuit which selects the horizontal lines to be displayed and is manufactured on the same substrate as the liquid crystal cells, characterized in that this select line scanner includes a shift register according to any one of the preceding claims.
